# EUROPÄISCHE PATENTSCHRIFT

(11) **EP 2 454 393 B1**
(45) Veröffentlichungstag und Bekanntmachung des Hinweises auf die Patenterteilung: **28.09.2016**
(21) Anmeldenummer: 10737527.1
(22) Anmeldetag: 14.07.2010
(51) Int. Cl.: C23C 14/00, C23C 14/06

(54) **VERFAHREN ZUR HERSTELLUNG VON WENDESCHNEIDPLATTEN**
METHOD FOR PRODUCING INDEXABLE INSERTS
PROCÉDÉ DE FABRICATION DE PLAQUETTES AMOVIBLES

(30) Priorität: 14.07.2009 DE 102009033192
(43) Veröffentlichungstag der Anmeldung: 23.05.2012
(73) Patentinhaber: MSM Krystall GBR, 12165 Berlin (DE)
(72) Erfinder: MECKLENBURG, Arno, 10999 Berlin (DE); SCHNEIDER, Rainer, 12165 Berlin (DE); MICHAELSEN, Rainer, 10589 Berlin (DE)
(74) Vertreter: Westphal, Mussgnug & Partner Patentanwälte mbB
(86) Internationale Anmeldenummer: PCT/EP2010/060163
(87) Internationale Veröffentlichungsnummer: WO 2011/006940

(56) Entgegenhaltungen:
- WO-A1-97/07257
- WO-A1-2006/118511
- WO-A1-2008/115550
- GB-A- 2 179 678
- US-A- 5 584 045

## Beschreibung

### Technisches Gebiet

Die Erfindung betrifft ein Verfahren zur Herstellung von Wendeschneidplatten durch Physikalische Gasphasenabscheidung (engl.: physical vapour deposition, kurz: PVD) von Schneidstoffen auf auflösbaren profilierten Substraten

### Hintergrund

Üblicherweise werden Wendeschneidplatten auf pulvermetallurgischem Wege bzw. durch Sintern hergestellt, wobei WC/Co (Wolframcarbid-Cobalt, allg. "Hartmetall") ein wichtiger Basiswerkstoff ist. Häufig werden Wendeschneidplatten mittels Physikalischer (PVD) oder Chemischer Gasphasenabscheidung (engl.: chemical vapour deposition, kurz: CVD) mit harten, abriebfesten und korrosionsbeständigen Beschichtungen versehen, um ihren Verschleiß zu mindern und/oder höhere Zerspanungsgeschwindigkeiten und bessere Schnittqualitäten zu ermöglichen. Zu den Verfahren der PVD gehören unter anderem thermisches Verdampfen, Elektronenstrahlverdampfen, (engl. electron beam evaporation), Laserstrahlverdampfen (engl. pulsed laser deposition, pulsed laser ablation), Lichtbogenverdampfen (engl. arc evaporation, Arc-PVD), Molekularstrahlepitaxie (engl. molecular beam epitaxy),
Sputtern, Ionenstrahlgestützte Deposition (engl. ion beam assisted deposition, IBAD) und Ionenplattieren. Die pulvermetallurgische Herstellung der eigentlichen Wendeschneidplatten ist mit verschiedenen Nachteilen behaftet, bei Hartmetall sind dies vor allem die Folgenden:
- Zum Erzielen der mit Hinblick auf die mechanische Verschleißfestigkeit wünschenswerten sehr kleinen Korngrößen (der Hartstoffphase, < 0.5 µm) müssen mit hohem Aufwand entsprechend feinkörnige Ausgangspulver erzeugt und möglichst unter Sauerstoffausschluss gehandhabt werden.
- Die Erzeugung porenfreier Sinterkörper mit homogenem Gefüge ist vielfach schwierig, gelingt nicht vollkommen, und erfordert häufig zusätzlichen technischen Aufwand wie heißisostatisches Pressen (engl.: hot isostatic pressing, kurz: HIP).
- Beim Sintern kommt es zu einem Kornwachstum, wodurch technisch erstrebenswerte Korngrößen im Nanometer-Bereich nicht erreichbar sind.
- Zahlreiche vielversprechende Materialsysteme (z.B. Legierungen), insbesondere hochwarmfeste, können wegen ihrer hohen Solidustemperaturen nicht oder nicht wirtschaftlich in Gestalt massiver Teile dargestellt werden.
- Die Einstellung spezieller Texturen wie Nanometer-Multilagensysteme ist mit den Mitteln der Pulvermetallurgie entsprechend dem Stand der Technik unmöglich.

Zur *Beschichtung* jedoch nicht zur *Herstellung* von Wendeschneidplatten ist die Physikalische Gasphasenabscheidung bekannt. Hergestellt werden Wendeschneidplatten aus Hartmetall üblicherweise mit Hilfe von Sinterverfahren. Es ist bekannt, dass PVD- oder CVD-Verfahren geeignet sind, amorphe oder wenig kristallisierte sowie nanokristalline Hartstoffsysteme abzuscheiden. Auch ist bekannt, derartige Schichten durch Wärmebehandlung zweckmäßig zu kristallisieren. Wegen der geringen Abscheidungsraten wird die Physikalische Gasphasenabscheidung zwar zur Erzeugung dünner Schichten, nicht jedoch zur Herstellung massiver Teile wie Wendeschneidplatten verwendet. Werden Physikalische Gasphasenbeschichtungen bei geringen Prozessdrücken gefahren, verhalten diese sich als "Sichtlinienverfahren", das heißt, Hinterschneidungen des Substrats werden nicht oder nur in geringem Umfang beschichtet, was bei der Beschichtung von Werkzeugen oftmals einen gravierenden Nachteil darstellt, der beispielsweise die kontrollierte Bewegung der zu beschichtenden Werkzeuge während der Schichtabscheidung erforderlich macht.

In der Publikation WO 2008/115550 A1 ist ein Verfahren zur Herstellung von kleinen Partikeln beschrieben. Die Publikation WO 2006/118511 offenbart ein Herstellverfahren für Wendeschneidplatten. Ein PVD-Verfahren, welches sich für Mehrschichtanwendungen eignet, wird in der Publikation WO 97/07257 beschrieben. Die Publikation GB 2179 678 A betrifft ein Sputterverfahren.

Es besteht ein Bedarf an einer möglichst wirtschaftlichen Herstellung von Wendeschneidplatten mit besonders feinem ("nanokristallinem"), gleichmäßigem und bedarfsweise hochgradig anisotropem Gefüge. Dabei sollen die unter "Stand der Technik" aufgeführten Schwächen der Pulvermetallurgie bzw. des Sinterns vollständig vermieden werden. Außerdem soll die parallele Darstellung möglichst vieler Endgeometrie-naher Wendeschneidplatten in einfacher Weise ermöglicht werden und kostengünstig sein.

### Zusammenfassung

Ein Aspekt der Erfindung betrifft die Verwendung eines Verfahrens zur Physikalischen Gasabscheidung (PVD-Verfahren) zur Herstellung eines Grundkörpers einer Wendeschneidplatte durch Abscheiden einer Schicht mit einer Dicke, die im Wesentlichen der Dicke der Wendeschneidplatte entspricht, gemäß Anspruch 1.

Es wird ein Verfahren zur Herstellung von Wendeschneidplatten offenbart. Gemäß einem Beispiel werden Endgeometrie-nahe Wendeschneidplatten hergestellt, indem ein profiliertes Substrat mittels Physikalischer Gasphasenabscheidung beschichtet wird, wonach das Substrat chemisch oder elektrochemisch aufgelöst wird. Die ermöglicht die Herstellung von Wendeschneidplatten aus Werkstoffen, die nicht gesintert werden können; außerdem werden Gefüge zugänglich (nanokristalline und mutlilagige, einschließlich nanoskalige Multilayersysteme), die mit herkömmlichen Verfahren nicht erhalten werden können. Die Beschichtung des Substrats vor der Abscheidung des eigentlichen Schneidwerkstoffes ermöglicht auch die Herstellung beschichteter Wendeschneidplatten in besonders einfacher Weise. Durch die ausgeprägte Skalierbarkeit vieler PVD-Verfahren ist es möglich, auf bekannten Anlagen sehr viele (bis zu einigen zehntausend) Schneidplättchen (Wendeschneidplatten) parallel herzustellen: Die Schneidplatten werden regelrecht gedruckt.

Als ein Beispiel wird ein Verfahren zur gleichzeitigen Herstellung einer Vielzahl von plättchenförmigen Elementen, insbesondere Wendeschneidplatten offenbart. Das Verfahren umfasst: das Bereitstellen eines strukturierten Substrates, wobei die Struktur des Substrats Bereiche festlegt, auf denen die plättchenförmigen Elemente erzeugt werden; das Abscheiden einer die plättchenförmigen Elemente bildenden Schicht mit Hilfe eines PVD-Verfahrens, mit dessen Hilfe Material aus einem Target entlang einer Beschichtungsrichtung zum Substrat befördert wird, um darauf die Schicht zu bilden; und das Auflösen des Substrats, wodurch plättchenförmigen Elemente vereinzelt werden,
wobei das Substrat derart strukturiert ist, dass zwischen jenen Bereichen des Substrats, auf denen die plättchenförmigen Elemente abgeschieden werden, Substratflächen liegen, die parallel zur Beschichtungsrichtung ausgerichtet sind oder die eine Hinterschneidung bilden, sodass an jenen Substratflächen kein oder vernachlässigbar wenig Material aus dem Target abgeschieden wird.

### Kurzbeschreibung der Abbildungen

Die folgenden Figuren und die weitere Beschreibung soll helfen, die Erfindung besser zu verstehen. Nähere Details, Varianten und Weiterentwicklungen des Erfindungsgedankens werden an Hand von Figuren erläutert, die ein spezielles ausgewähltes Beispiel betreffen. Die Elemente in den Figuren sind nicht unbedingt als Einschränkung zu verstehen, vielmehr wird Wert darauf gelegt, das Prinzip der Erfindung darzustellen. In den Figuren bezeichnen gleiche Bezugszeichen korrespondierende Teile.
- Fig. 1: illustriert anhand einer schematisch skizzierten Anordnung das Prinzip der Physikalischen Gasphasenabscheidung (PVD) auf einem Substrat;
- Fig. 2: illustriert anhand eines einfachen Beispiels, wie mit einer Hinterschneidung auf dem Substrat die PVD-Schicht unterbrochen werden kann;
- Fig. 3: illustriert ein strukturiertes Substrat mit einer dicken PVD-Schicht zur Herstellung einer Vielzahl von Wendeschneidplatten;
- Fig. 4: illustriert ein strukturiertes Substrat mit einer dünnen CVD-Schicht und einer darauf aufgebrachten dicken PVD-Schicht zur Herstellung einer Vielzahl von beschichteten Wendeschneidplatten.

### Detaillierte Beschreibung

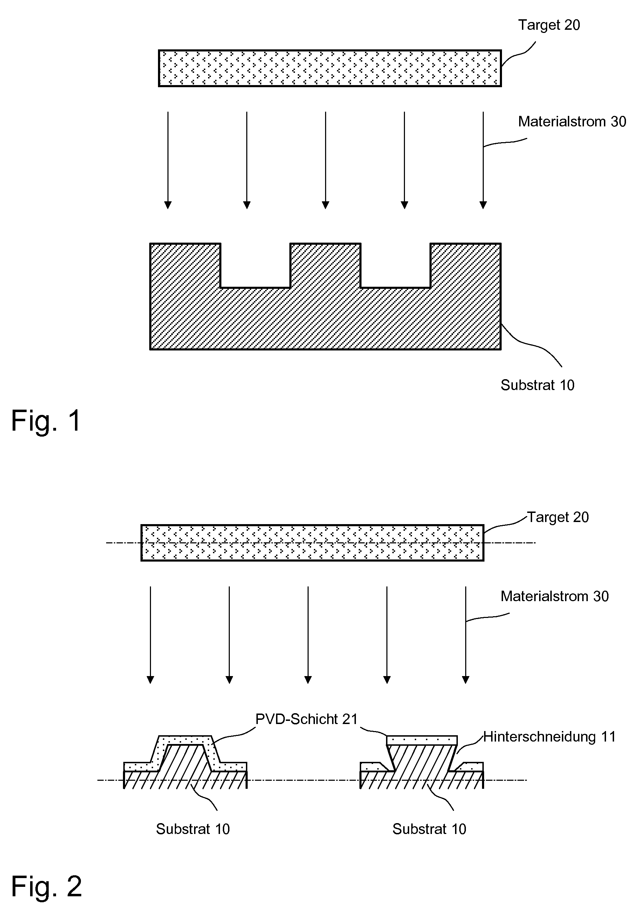

Figur 1 illustriert vereinfacht das Prinzip des Prozesses der der Physikalischen Gasphasenabscheidung (PVD). Ein zu beschichtendes Substrat 10 ist zusammen mit einem sogenannten Target 20 (allgemein Material-Quelle) in einer Prozessumgebung angeordnet. Abhängig von dem jeweiligen PVD-Verfahren werden aus dem Target 10 ein die Schichtbildenden Teilchen herausgelöst und so ein Gas oder ein (z.B. ionisiertes) Plasma erzeugt, die Teilchen aus dem Target 20 werden zu dem Substrat 10 transportiert (siehe Fig. 1: Materialstrom 30) und kondensieren auf dem Substrat 10, wodurch die PVD-Schicht gebildet wird. Je nach PVD-Prozess können die Materialteilchen aus dem Target 20 auch mit Atomen oder Molekülen aus der Prozessatmosphäre reagieren, bevor sie auf dem Substrat 10 kondensieren und eine PVD-Schicht bilden. Z.B. kann eine Schicht aus Titannitrid aus einem Titan-Target erzeugt werden, wobei die aus dem Target 20 herausgelösten Titanteilchen in einer Stickstoffatmosphäre zu Titannitrid reagieren. Es sind unterschiedliche PVD-Verfahren bekannt, weshalb darauf nicht im Detail eingegangen wird. Bei den beschriebenen Ausführungsbeispielen können verschiedene PVD-Verfahren eingesetzt werden. Gute experimentelle Ergebnisse wurden z.B. durch Sputtern erzielt.

Figur 2 illustriert eine im Allgemeinen als nachteilig angesehene Eigenschaft der Physikalischen Gasphasenabscheidung. Eine Materialabscheidung findet nur in der Richtung des Materialtransports vom Target 20 zum Substrat 10 statt, sodass hinter Hinterschneidungen (siehe Fig. 2, Hinterschneidung 11) im Substrat dieses nicht beschichtet wird Des weiteren wird auf Flächen die parallel zur Richtung des Materialtransports (Richtung des Schichtdickenwachstums) kein oder vernachlässigbar wenig Material abgeschieden.

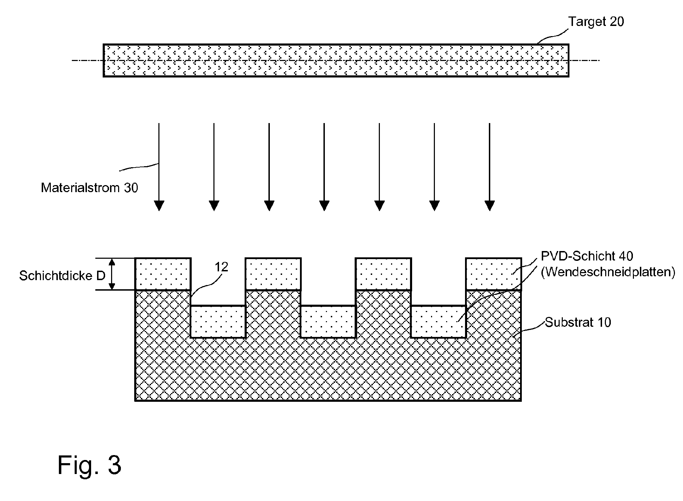

Gemäß einem Beispiel wird ein profiliertes (d.h. entsprechend der Soll-Form der Wendeschneideplatten strukturiertes) Substrat 10, beispielsweise aus einer Aluminium-Titan-Legierung, mittels eines Verfahrens der Physikalischen Gasphasenabscheidung beschichtet (siehe Fig. 3: PVD-Schicht 40). Wie oben unter Bezugnahme auf Figur 2 erläutert wird bei hinreichend geringem Druck das Substrat 10 wegen seines Profils höchst ungleichmäßig beschichtet: Auf Hinterschneidungen bzw. Flächen, welche senkrecht auf die Ebene, in der das Target liegt, stehen, wird kein bzw. sehr wenig Material abgeschieden. Wird nun das Substrat 10 chemisch (z.B. durch Ätzen) oder elektrochemisch aufgelöst (d.h. das Substrat 10 wird entfernt), so erhält man die abgeschiedene Schicht 40 in Form diskreter freistehender Teile, welche bei geeigneter Formgebung des Substrates bereits die Form der herzustellenden Wendeschneidplatten besitzen können. Das Substrat kann aus mehreren miteinander lösbar verbundenen (verschraubten) Teilen bestehen, sodass nur ein Teil des Substrats 10 aufgelöst werden muss. Der/Die andere(n) Teil(e) des Substrats 10 kann/können mechanisch entfernt werden (z.B. durch Lösen der Schrauben). Beispielsweise kann ein Substrat aus einem plattenförmigen Grundkörper bestehen und einer darauf befestigten Maske, wobei die Maskenöffnungen die spätere Form der Schneidplättchen bestimmt. Nach dem Abscheiden der Schneidplättchen kann jener Teil des Substrats, der die Maske bildet, vom Grundkörper des Substrats werden, sodass nur der Grundkörper des Substrats aufgelöst werden muss.

Die Form der vereinzelten Teile hat aufgrund der Formgebung des Substrat bereits ihre endgültige Geometrie (bzw. sind sehr nahe an der endgültigen Geometrie), was als "Endgeometrie-nahe" bezeichnet wird. Eine Nachbearbeitung der Form ist nicht oder in nur sehr geringem Umfang nötig. Auf diese Art können eine Vielzahl (mehrere Tausend) von Wendeschneidplatten gleichzeitig erzeugt werden. Die Vielzahl der Wendeschneidplatten, die mit dem erfindungsgemäßen Verfahren gleichzeitig hergestellt werden können, kompensieren den Nachteil, dass das Herstellen entsprechend dicker PVD-Schichten (größer 500µm, auch größer 1000µm) entsprechend lange dauert (bis zu 24 Stunden oder länger).

Ein Beispiel des oben beschriebenen Verfahrens ist in Figur 3 dargestellt. Die einzelnen Bereiche des Substrats 10, auf dem die Wendeschneidplatten abgeschieden werden, sind zueinander in der Höhe versetzt angeordnet. Auf jenen Flächen, die normal zur (im vorliegenden Beispiel horizontalen) Ebene, in der das Substrat 10, liegen wird - wie oben erläutert - kein Material (d.h. vernachlässigbar wenig) abgeschieden, sodass die Wendeschneidplatten 40 nach dem Auflösen des Substrats bereits vereinzelt sind.

Die gewünschte Korngröße und Spannungsfreiheit können durch eine Wärmebehandlung nach bekannten Verfahren unter Schutzgas oder im Vakuum eingestellt werden.

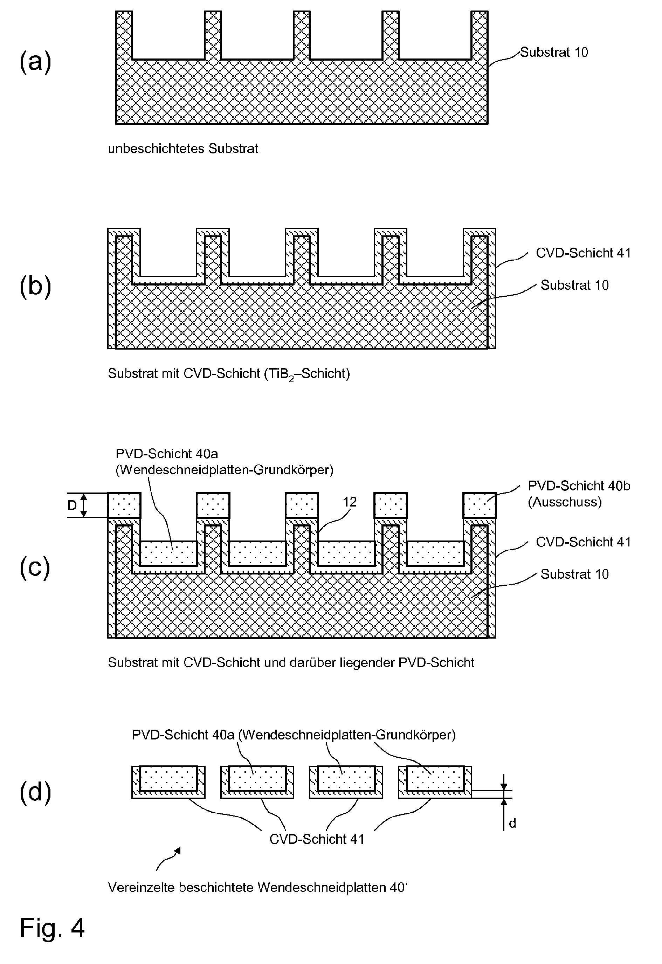

Gemäß einem weiteren, in den Figuren 4a-d gezeigten Beispiel wird das Substrat 10 vor der Abscheidung der späteren Wendeschneidplatten (siehe Fig. 4c, PVD-Schicht 40a) nach einem bekannten Verfahren beschichtet (siehe Fig. 4c, CVD-Schicht 41), beispielsweise mittels Chemischer Gasphasenabscheidung (engl. chemical vapour deposition, kurz: CVD) mit einigen µm Titandiborid (TiB₂), wobei das Verfahren zur Auflösung des Substrates 10 derart geeignet ausgewählt wird, sodass nur das Substrat 10 aufgelöst, jedoch der Basiswerkstoff (PVD-Schicht 40a)und die Beschichtung (CVD-Schicht 41) nicht oder nur wenig angegriffen werden. Auf diese Weise werden die freistehenden Teile 40a inklusive CVD-Beschichtung 41 erhalten, wobei die dem Target 20 zugewandte Seite unbeschichtet bleibt, was vorteilhaft ist, wenn die Wendeschneidplatten 40a auf Träger aufgelötet werden sollen.

Gemäß einem weiteren Beispiel werden mehrere Quellen (in vielen PVD-Verfahren als Targets bezeichnet) aus unterschiedlichen Materialien abwechselnd gebraucht, um Wendeschneidplatten aus multilagigen Schneidstoffen zu erzeugen, wobei beispielsweise ein erstes Target aus Tantal und ein zweites Target aus Glaskohlenstoff bestehen kann. Dabei wird die Schichtdicke derart gewählt, dass mittels einer Wärmebehandlung durch Diffusion abwechselnde Schichten - beispielsweise aus Tantalcarbid (TaC) und (sp²-hybridisiertem) Kohlenstoff - erzeugt werden.

Es werden also die Vorteile der Physikalischen Gasphasenabscheidung ausgenutzt, sowie auch die im Allgemeinen nachteilhafte Eigenschaft dieser Verfahren, Hinterschneidungen nicht oder nur wenig zu beschichten. Außerdem können mit dem neuen Verfahren multilagige Wendeschneidplatten, selbst solche mit Lagendicken im Nanometerbereich, in einfacher Weise hergestellt werden. Derartige Multilagensysteme können neben besonders hoher Härte und Warmfestigkeit auch außerordentlich zäh sein, weitaus zäher als die reinen Basiswerkstoffe der einzelnen Lagen, was für die Anwendung in Wendeschneidplatten, vor allem im unterbrochenen Schnitt, vorteilhaft ist. Auch sind Multilagensysteme bezüglich ihrer mechanischen Eigenschaften inhärent anisotrop, was in Wendeschneidplatten ausgenutzt werden kann, da deren mechanische Beanspruchung gleichfalls in höchstem Maße anisotrop sind.

Des Weiteren wird die Skalierbarkeit in der Fläche ausgenutzt: Selbst ein durch niedrige Raten gekennzeichnetes Verfahren wie z.B. die Kathodenzerstäubung ist nur scheinbar untauglich zur wirtschaftlichen Herstellung von Vollmaterial. PVD-Anlagen (z.B. Kathodenzerstäubungsanlagen) mit vielen Quadratmetern Substratfläche erlauben bei erfindungsgemäßem Gebrauch die Erzeugung zehntausender Wendeschneidplatten handelsüblicher Geometrie pro Tag.

Verschiedene wichtige Aspekte des erfindungsgemäßen Verfahrens werden im Folgenden noch einmal (ohne Anspruch auf Vollständigkeit) zusammengefasst.

Ein Ausführungsbeispiel des Verfahrens zur gleichzeitigen Herstellung einer Vielzahl von plättchenförmigen Elementen (wie z.B. Wendeschneidplatten aus Hartmetall) umfasst die folgenden Schritte:
- Bereitstellen eines strukturierten Substrates 10 (siehe Fig. 4a) ;
- Abscheiden einer die plättchenförmigen Hartmetallelemente 40' bildenden Schicht 40a, 40b mit Hilfe eines PVD-Verfahrens;
- Auflösen des Substrats 10, wodurch plättchenförmigen Hartmetallelemente 40' vereinzelt werden.

Das Substrat ist dabei so strukturiert, dass zwischen jenen Bereichen des Substrats 10, auf denen die plättchenförmigen Hartmetallelemente abgeschieden werden, Substratflächen 12 liegen, die parallel zur Beschichtungsrichtung ausgerichtet sind oder die zum Substrat 10 eine Hinterschneidung bilden, sodass an jenen Substratflächen 12 kein (oder vernachlässigbar wenig) Material aus dem Target 20 abgeschieden wird.

Der Abscheidungsprozess kann dabei derart gesteuert werden, dass der Stoff der abgeschiedenen PVD-Schicht 40, 40a, 40b ganz oder überwiegend in nanokristalliner Form vorliegt, wodurch die Härte und die Zähigkeit der abgeschiedenen Schicht (d.h. des Schneidplättchens) nennenswert erhöht werdenkann. Zusätzlich kann die abgeschiedene PVD-Schicht 40, 40a, 40b zum Relaxieren der Eigenspannungen und/oder zur Einstellung der Mikrostruktur einer Wärmebehandlung unterzogen werden.

Optional kann vor dem Abscheiden der plättchenförmigen Hartmetallelemente 40, 40a mittels PVD das Substrat 10 mit einer weiteren Schicht 41 (z.B. aus Titandiborid, TiB₂), beispielsweise mittels CVD, beschichtet werden. Nach dem entfernen des Substrats 10 bleibt die weitere Schicht 41 auf der danach abgeschiedenen PVD-Schicht 40, 40a. Auf diese Weise können z.B. mit TiB₂ beschichtete Wendeschneidplatten hergestellt werden.

Zur Herstellung von plättchenförmigen Elementen, die sich z.B. als Wendeschneidplatten eignen und die eine besonders hohe Warmfestigkeit sowie eine besonders große Zähigkeit aufweisen, kann nach bekannten PVD-Verfahren ein Schneidstoff abgeschieden werden, der z.B. Tantal, Kohlenstoff, Wolfram oder Rhenium enthält. Die Zusammensetzung des Schneidstoffs kann dabei derart gewählt werden, dass durch Wärmebehandlung der freistehenden Teile ein mehrphasiges Gefüge erhalten werden kann, welches mehr als 70 Volumsprozent Carbid enthält sowie eine duktile Wolfram-Rhenium-Phase. Die duktile Wolfram-Rhenium-Phase enthält dabei zwischen 10 und 28 Atomprozent Rhenium, insbesondere zwischen 22 und 28 Atomprozent Rhenium. Das erwähnte mehrphasige Gefüge kann mehrere Carbidphasen enthalten, von denen eine aus Tantalcarbid(en) (TaCₓ) und eine weitere aus Wolframcarbid (W₂C) besteht. Der Schneidstoff kann zusätzlich mit weniger als 5 Atomprozent Chrom und/oder Vanadium (gesamt) dotiert sein.

Gemäß einem weiteren Beispiel des Verfahrens wird eine Vielzahl von plattenförmigen Elementen (z.B. Wendeplatten) durch Physikalische Gasphasenabscheidung auf einem Substrat 10 hergestellt, wobei bei dem verwendeten PVD-Verfahren mehrere Material-Quellen (Targets) verwendet werden, um mehrlagige PVD-Schichten zu erzeugen. Ein Target kann dabei überwiegend aus Kohlenstoff und mindestens eine weitere Quelle überwiegend aus einem oder mehreren Carbidbildnern bestehen. Bei der Verwendung eines Sputter-Verfahrens zur PVD kann das überwiegend kohlenstoffhaltige Sputter-Target aus Glaskohlenstoff bestehen. Als Carbidbildner kann eines der folgenden Materialien oder eine beliebige Kombination der folgenden Materialien verwendet werden: Wolfram, Titan, Zirconium, Hafnium, Tantal, Chrom, Vanadium und Niob. Die Schichtdicken können dabei derart bemessen werden, dass durch Wärmebehandlung der plättchenfömigen Elemente diese mit abwechselnden Lagen aus Carbid und sp²-hybridisiertem Kohlenstoff erzeugt werden. Die Carbidschichten können in den fertigen plättchenförmigen Elementen (Wendeschneidplatten) dicker sein als die Kohlenstoffschichten. Die mittlere Dicke der Carbidschichten ist beispielsweise kleiner als 0.6 µm. Bei der Verwendung mehrerer Carbidbildner kann man mehrere Carbidphasen erhalten, von denen wenigstens eine in nanokristalliner Form vorliegen soll.

Die vereinzelten plättchenförmige Elemente (Wendeschneidplatten) können freistehend verwendet oder auf einem Träger aus Hartmetall oder Schnellarbeitsstahl aufgelötet (oder angeschweißt) werden, und anschließend als Schneidwerkzeug verwendet werden. Die vereinzelten Plättchen können bereits vor einer Wärmebehandlung auf die erwähnten Träger aufgebracht und mit diesen verlötet oder verschweißt werden, wobei das Löten oder Schweißen mit der Wärmebehandlung in einem Arbeitsschritt erfolgt.

Geeignete Werkstoffe für das Substrat 10 sind z.B. Aluminium oder Titan oder Legierungen, die Aluminium und/oder Titan enthalten. Das Auflösen des Substrates 10 kann auf chemischem Wege (z.B. Ätzen) oder elektrochemischem Wege (z.B. Anodisieren) erfolgen. Als Ätzmittel kommen z.B. Natron- oder Kalilauge sowie verschiedene Mineralsäuren in Betracht. Die Oberfläche des Substrats kann in situ vorbereitet werden, indem das Substrat vor der PVD-Beschichtung selbst als Kathode geschaltet und oberflächlich zerstäubt wird.

## Patentansprüche

1. Verfahren zur Herstellung von Schneidplatten, das Folgendes aufweist:
- Abscheiden einer die Schneidplatten bildenden Schicht aus Hartmetall mittels eines PVD-Verfahrens auf ein auflösbares profiliertes Substrat, wobei die abgeschiedene Schicht im Wesentlichen der Dicke der Schneidplatte entspricht, und
- Auflösen des Substrates, um in Gestalt frei stehende Teile als Schneidplatten zu erhalten.

2. Verfahren nach Anspruch 1, wobei das PVD-Verfahren derart gesteuert wird, dass das abgeschiedene Hartmetall ganz oder überwiegend in nanokristalliner Form vorliegt.

3. Verfahren nach Anspruch 1 oder 2, das weiter aufweist:
Wärmebehandeln der Schneidplatten zum Relaxieren der Eigenspannungen und/oder zur Einstellung der Mikrostruktur.

4. Verfahren nach einem der Ansprüche 1 bis 3, **gekennzeichnet dadurch, dass** die freistehenden Teile eine Dicke (D) größer 50 µm oder eine Dicke größer 100 µm oder eine Dicke größer 250 µm besitzen.

5. Verfahren nach einem der Ansprüche 1 bis 4 **gekennzeichnet dadurch, dass** das Hartmetall aus Tantal, Kohlenstoff, Wolfram und Rhenium besteht.

6. Verfahren nach Anspruch 5 **gekennzeichnet dadurch, dass** die Zusammensetzung des Schneidstoffs derart gewählt wird, dass durch Wärmebehandlung der freistehenden Teile ein mehrphasiges Gefüge erhalten werden kann, welches > 70 Vol% Carbid enthält sowie eine duktile Wolfram-Rhenium-Phase.

7. Verfahren nach einem der Ansprüche 1 bis 6 **gekennzeichnet dadurch, dass** beim PVD-Verfahren zu Abscheidung des Hartmetalls mindestens eine Quelle überwiegend aus Kohlenstoff und mindestens eine weitere Quelle überwiegend aus einem oder mehreren Carbidbildnern besteht, dass
das überwiegend kohlenstoffhaltige Sputter-Target aus Glaskohlenstoff besteht, und dass als Carbidbildner Wolfram und/oder Titan und/oder Zirconium und/oder Hafnium und/oder Tantal und/oder Chrom und/oder Vanadium und/oder Niob verwendet werden.

8. Verfahren nach einem der Ansprüche 1 bis 6 **gekennzeichnet dadurch, dass** beim PVD-Verfahren zu Abscheidung des Hartmetalls mindestens eine Quelle überwiegend aus Kohlenstoff und mindestens eine weitere Quelle überwiegend aus einem oder mehreren Carbidbildnern besteht, dass
das überwiegend kohlenstoffhaltige Sputter-Target aus Glaskohlenstoff besteht, und dass
die Schichtdicken derart bemessen werden, dass durch Wärmebehandlung der freistehenden Teile diese mit abwechselnden Lagen aus Carbid und sp²-hybridisiertem Kohlenstoff erhalten werden.

9. Verfahren nach Anspruch 8 **gekennzeichnet dadurch, dass** die Carbidschichten in den fertigen Teilen dicker sind als die Kohlenstoffschichten.

10. Verfahren nach einem der Ansprüche 1 bis 6 **gekennzeichnet dadurch, dass** beim PVD-Verfahren zu Abscheidung des Hartmetalls mindestens eine Quelle überwiegend aus Kohlenstoff und mindestens eine weitere Quelle überwiegend aus einem oder mehreren Carbidbildnern besteht, dass
das überwiegend kohlenstoffhaltige Sputter-Target aus Glaskohlenstoff besteht, und dass mehrere Carbidbildner derart verwendet werden, dass mehrere Carbidphasen erhalten werden, von denen wenigstens eine nanokristallin vorliegt.

11. Verfahren nach einem der Ansprüche 1 bis 10 **gekennzeichnet dadurch, dass** vor und/oder nach der Abscheidung des Hartmetalls eine oder zwei verglichen mit der Dicke des freistehenden Teils dünne Schicht(en) aus bekannten Hartstoff durch Kathodenzerstäubung abgeschieden wird/werden, so dass nach dem Ablösen freistehende Teile erhalten werden, welche auf einer oder zwei Seiten (oben/unten) mit bekannten Hartstoff beschichtet ist/sind.

12. Verfahren nach einem der Ansprüche 1 bis 11 **gekennzeichnet dadurch, dass** das auflösbare profilierte Substrat vor dem Abscheiden einer die Schneidplatten bildenden Schicht nach einem bekannten Verfahren, insbesondere Verfahren der Chemischen Gasphasenabscheidung, mit einem bekannten Hartstoff beschichtet wird, so dass nach dem Auflösen des Substrates freistehende Teile erhalten werden, welche auf mehreren Seiten mit dem bekannten Hartstoff beschichtet sind.

13. Verfahren nach Anspruch 2 **gekennzeichnet dadurch, dass** die freistehenden Teile vor der Wärmebehandlung auf Träger aus Hartmetall oder Schnellarbeitsstahl aufgebracht und mit diesen verlötet oder verschweißt werden, wobei das Löten oder Schweißen mit der Wärmebehandlung in einem Schritt erfolgt.

14. Verfahren gemäß Anspruch 1, wobei das Substrat derart strukturiert, dass zwischen jenen Bereichen des Substrats (10), auf denen die Schneidplatten abgeschieden werden, Substratflächen (12) liegen, die parallel zur Beschichtungsrichtung ausgerichtet sind oder die eine Hinterschneidung bilden, sodass an jenen Substratflächen (12) kein oder vernachlässigbar wenig Material aus dem Target (20) abgeschieden wird.

15. Verfahren nach Anspruch 1, das vor dem Abscheiden der die Schneidplatten (40') bildenden Schicht (40; 40a, 40b) noch Folgendes umfasst:
- Beschichten des Substrats (10) mit einer weiteren Schicht (41), insbesondere mit Hilfe eines CVD-Verfahrens.

16. Verwendung eines Verfahrens zur Physikalischen Gasabscheidung zur Herstellung eines Grundkörpers einer Wendeschneidplatte durch Abscheiden einer Schicht aus Hartmetall mit einer Dicke, die im Wesentlichen der Dicke der Wendeschneidplatte entspricht.

## Claims

1. Method for the manufacture of cutting inserts, comprising:
- depositing a layer of hard metal, forming the cutting inserts, on a dissolvable profiled substrate using a PVD
(Physical Vapor Deposition) process, whereby the deposited layer substantially corresponds to the thickness of the cutting insert, and
- dissolving the substrate to obtain cutting inserts configured as free-standing parts.

2. Method according to claim 1, whereby the PVD process is regulated such that the deposited hard metal is present entirely or mainly in nano-crystalline form.

3. Method according to claim 1 or 2, further comprising:
- thermally treating the cutting insert in order to relax the internal stress and/or to adjust the microstructure.

4. Method according to the claims 1 to 3, **characterized in that** the free-standing parts have a thickness (D) greater than 50 µm or a thickness greater than 100 µm or a thickness greater than 250 µm.

5. Method according to one of the claims 1 to 4, **characterized in that** the hard metal is composed of tantalum, carbon, wolfram and rhenium.

6. Method according to claim 5, **characterized in that** the composition of the cutting material is chosen such that a multiphase structure containing > 70 Vol. % carbide and a ductile wolfram-rhenium phase can be obtained by thermally treating the free-standing parts.

7. Method according to one of claims 1 to 6, **characterized in that** during the PVD process of depositing the hard metal, at least one source is predominantly composed of carbon and at least one further source is predominantly composed of one or more carbide formers, that
the predominantly carbonaceous sputter target is composed of glassy carbon,
and that wolfram and/or titan and/or zirconium and/or hafnium and/or tantalum and/or chrome and(or vanadium and/or niobium is(are) used as carbide former.

8. Method according to one of the claims 1 to 6, **characterized in that**, during the PVD process of depositing the hard metal at least one source is predominantly composed of carbon and at least one further source is predominantly composed of one or more carbide formers, that
the predominantly carbonaceous sputter target is composed of glassy carbon and that
the layer thicknesses are calculated so that, when thermally treated, the free-standing parts are obtained having alternating layers of carbide and sp²-hybridized carbon.

9. Method according to claim 8, **characterized in that** the carbide layers in the finished parts are thicker than the carbon layers.

10. Method according to one of the claims 1 to 6, **characterized in that**, in the PVD process of depositing the hard metal at least one source is predominantly composed of carbon and at least one further source is predominantly composed of one or more carbide formers, that
the predominantly carbonaceous sputter target is composed of glassy carbon and that numerous carbide formers are used such that numerous carbide phases are obtained, of which at least one is nano-crystalline.

11. Method according to the claims 1 to 10, **characterized in that**, before and/or after the depositing of the hard metal, one or two thin, compared to the thickness of the free-standing part, layer(s) of known hard material is/are deposited by means of cathode sputtering so that, after dissolving, free-standing parts are obtained that are coated with known hard material on one or two sides (above/below).

12. Method according to claims 1 to 11, **characterized in that** the dissolvable profiled substrate, before the depositing of a layer forming the cutting inserts, is coated with a known hard material in accordance with a known process, in particular the process of chemical vapor deposition, so that, after dissolving the substrate, free-standing parts are obtained that are coated with the known hard material on numerous sides.

13. Method according to claim 2, **characterized in that** the free-standing parts, before thermal treatment, are mounted on supports made of hard metal or high-speed steel and soldered or welded onto them, whereby the soldering or the welding is carried out in one step together with the thermal treatment.

14. Method according to claim 1, whereby the substrate is structured such that substrate surfaces (12), running parallel to the coating direction or forming an undercut, lie between those regions of the substrate (10) on which the cutting inserts are deposited so that no or negligibly little material is deposited from the target (20) onto these substrate surfaces (12).

15. Method according to claim 1 which, before the deposition of the layer (40; 40a, 40b) that forms the cutting inserts (40'), also comprises:
- coating the substrate (10) with a further layer (41), in particular with the aid of a CVD process.

16. Using a process of physical vapor deposition for the manufacture of a base body of an indexable insert by means of depositing a layer of hard metal having a thickness that essentially corresponds to the thickness of the indexable insert.

## Revendications

1. Procédé d'obtention de plaques de coupe comprenant les étapes suivantes consistant à :
- déposer une couche en un métal dur formant les plaques de coupe par un procédé PVD sur un substrat profilé soluble, la couche déposée correspondant essentiellement à l'épaisseur de la plaque de coupe, et
- dissoudre le substrat pour obtenir des pièces de configuration autonome constituant les plaques de coupe.

2. Procédé conforme à la revendication 1,
selon lequel le procédé PVD est commandé de sorte que le métal dur déposé se trouve en totalité ou principalement sous forme nanocristalline.

3. Procédé conforme à la revendication 1 ou 2,
comprenant en outre une étape consistant à effectuer un traitement thermique des plaques de coupe pour relaxer les tensions propres et/ou régler la microstructure.

4. Procédé conforme à l'une des revendications 1 à 3,
**caractérisé en ce que**
les pièces autonomes ont une épaisseur (D) supérieure à 50 µm ou une épaisseur supérieure à 100 µm ou une épaisseur supérieure à 250 µm.

5. Procédé conforme à l'une des revendications 1 à 4,
**caractérisé en ce que**
le métal dur est constitué par du tantale, du carbone, du tungstène, ou du rhenium.

6. Procédé conforme à la revendication 5,
**caractérisé en ce que**
la composition du matériau de coupe est choisi de sorte que, par traitement thermique des pièces autonomes ou puisse obtenir une structure multi-phasée renfermant plus de 70% en volume de carbure ainsi qu'une phase de tungstène-rhénium ductile.

7. Procédé conforme à l'une des revendications 1 à 6,
**caractérisé en ce que**
lors de la mise en oeuvre du procédé PVD pour permettre le dépôt du métal dur, on utilise au moins une source principalement en carbone et au moins une autre source principalement en un ou plusieurs agents de formation de carbure, la cible de pulvérisation renfermant principalement du carbone est en un carbone vitrifié, et en tant qu'agent de formation de carbure on utilise du tungstène et/ou du titane et/ou du zirconium et/ou du hafnium et/ou du tantale et/ou du chrome et/ou du vanadium et/ou du niobium.

8. Procédé conforme à l'une des revendications 1 à 6,
**caractérisé en ce que**
lors de la mise en oeuvre du procédé PVD pour permettre le dépôt du métal dur, on utilise au moins une source principalement en carbone et au moins une autre source principalement en un ou plusieur(s) agent(s) de formation de carbure, la cible de pulvérisation renfermant principalement du carbone est constituée de carbone vitrifié, et
les épaisseurs de couche sont dimensionnées de sorte que par traitement thermique des pièces autonomes ces pièces sont constituées de couches successives de carbure et de carbone à hybridation sp².

9. Procédé conforme à la revendication 8,
**caractérisé en ce que**
dans les pièces finales les couches de carbure sont plus épaisses que les couches de carbone.

10. Procédé conforme à l'une des revendications 1 à 6,
**caractérisé en ce que**
lors de la mise en oeuvre du procédé PVD pour permettre le dépôt du métal dur on utilise au moins une source principalement en carbone et au moins une autre source principalement en un ou plusieurs agent(s) de formation de carbure,
la cible de pulvérisation renfermant principalement du carbone est constituée d'un carbone vitrifié, et
on utilise plusieurs agents de formation de carbure de façon à obtenir plusieurs phases de carbure dont au moins l'une est nanocristalline.

11. Procédé conforme à l'une des revendications 1 à 10,
**caractérisé en ce que**
avant et/ou après le dépôt du métal dur, on dépose une ou deux couche(s) mince(s) par comparaison avec l'épaisseur de la pièce autonome en matière dure connue par pulvérisation cathodique de sorte qu'après dissolution on obtienne des pièces autonomes qui sont recouvertes sur une ou deux face(s) (supérieure / inférieure) d'une matière dure connue.

12. Procédé conforme à l'une des revendications précédentes,
**caractérisé en ce que**
le substrat profilé soluble est revêtu avant le dépôt d'une couche formant les plaques de coupe, selon un procédé connu en particulier un profilé de dépôt chimique en phase gazeuse, d'un matériau dur connu de sorte que, après dissolution du substrat on obtienne des pièces autonomes qui sont recouvertes sur plusieurs faces du matériau dur connu.

13. Procédé conforme à la revendication 2,
**caractérisé en ce que**
avant le traitement thermique les pièces autonomes sont appliquées sur un support en un métal dur ou un acier à coupe rapide et sont brasées ou soudées avec ce support, le brasage ou le soudage s'effectuant en une étape avec le traitement thermique.

14. Procédé conforme à la revendication 1,
selon lequel le substrat (10) est structuré de sorte que,
entre chacune des zones du substrat (12) sur lesquelles sont déposées les plaques de coupe, sont situées des surfaces de substrat (12) qui sont orientées parallèlement à la direction de revêtement ou qui forment une contre-dépouille de sorte que sur chaque surface (12) du substrat aucun ou une quantité négligeable de matériau de la cible (20) ne soit déposé.

15. Procédé conforme à la revendication 1,
selon lequel avant le dépôt de la couche (40, 40a, 40b) formant les plaques de coupe (40') on recouvre le substrat (10) d'une autre couche (41) en particulier à l'aide d'un procédé CVD.

16. Utilisation d'un procédé de dépôt physique en phase gazeuse pour l'obtention d'un corps de base d'une plaque de coupe réversible par dépôt d'une couche en un métal dur ayant une épaisseur qui correspond essentiellement à l'épaisseur de la plaque de coupe réversible.
